# EUROPÄISCHE PATENTSCHRIFT

(11) **EP 1 057 384 B1**
(45) Veröffentlichungstag und Bekanntmachung des Hinweises auf die Patenterteilung: **09.02.2005**
(21) Anmeldenummer: 99966830.4
(22) Anmeldetag: 07.12.1999
(51) Int. Cl.: H05K 1/14, B60R 16/02

(54) **ELEKTRONISCHES STEUERGERÄT**
ELECTRONIC CONTROL DEVICE
APPAREIL DE COMMANDE ELECTRONIQUE

(30) Priorität: 16.12.1998 DE 19857959
(43) Veröffentlichungstag der Anmeldung: 06.12.2000
(73) Patentinhaber: ROBERT BOSCH GMBH, 70442 Stuttgart (DE)
(72) Erfinder: RAU, Martin, D-71739 Oberriexingen (DE); SCHIEFER, Peter, D-74199 Untergruppenbach (DE)
(86) Internationale Anmeldenummer: PCT/DE1999/003901
(87) Internationale Veröffentlichungsnummer: WO 2000/036887

(56) Entgegenhaltungen:
- EP-A- 0 446 367
- DE-A- 19 605 966
- US-A- 4 629 278
- US-A- 5 581 130

## Beschreibung

### Stand der Technik

Die Erfindung betrifft ein elektronisches Steuergerät mit den im Oberbegriff des Anspruchs 1 angegebenen Merkmalen.

Aus der DE 196 05 966 A1 ist bereits ein Baugruppenträger für ein elektronisches Steuergerät bekannt, der auf seiner Bestückungsseite mit mehreren Elektronikmodulen versehen ist. Die Elektronikmodule sind mit je einer elektronischen Schaltung versehen, die unabhängig von den übrigen Elektronikmodulen wenigstens eine separate Funktion des Steuergerätes erzeugt. Durch die Kombination verschiedener Elektronikmodule auf dem Baugruppenträger kann das Steuergerät an ein vorgegebenes Anforderungsprofil hinsichtlich der Ansteuerung verschiedener Betriebseinheiten angepaßt werden. So ist es beispielsweise möglich, mehrere Elektronikmodule zur Steuerung von Motor, Antiblockiersystem, elektronischem Gaspedal, Abstandsradar, Stellantrieben oder anderen Betriebseinrichtungen eines Kraftfahrzeuges auf einem Baugruppenträger in einem zentralen Steuergerät des Kraftfahrzeuges anzuordnen.

Nachteilig bei den bekannten Steuergeräten ist, daß der Baugruppenträger zum Anschluß der Betriebseinrichtungen mit einer in einer Seitenwand des Steuergerätes angeordneten Stekkerleiste oder mit einer Leiterfolie konataktiert ist, die mit Steckverbindern außerhalb des Steuergerätes verbunden ist. Die Leiterfolie oder Steckerleiste wird an einer Seite des Baugruppenträgers mit den Leiterbahnen des Baugruppenträgers beispielsweise durch Löten oder über Bonddrähte elektrisch verbunden. Da alle Anschlüsse an einer Seite des Baugruppenträgers angeordnet sind, ist eine aufwendige Leiterbahnführung auf dem Baugruppenträger erforderlich, um die Vielzahl der Anschlußleitungen mit zugeordneten Elektronikmodulen elektrisch zu verbinden. So müssen manche Leiterbahnen über den ganzen Baugruppenträger zu einem von der Stekkerleiste entfernt liegenden Elektronikmodul geführt werden. Darüber hinaus muß der Baugruppenträger an die Breite der Steckerleiste oder Leiterfolie angepaßt werden, ansonsten können nicht alle Kontaktelemente der Steckerleiste oder Leiterfolie mit dem Baugruppenträger verbunden werden. Da die Anzahl der Kontaktelemente der Steckerleiste oder Leiterfolie mit zunehmender Integrationsdichte auf dem Baugruppenträger stark anwächst, müssen entsprechend breite Baugruppenträger verwandt werden, wodurch sich die Herstellungskosten des Steuergerätes erheblich vergrößern und der Platzbedarf des Steuergerätes im Kraftfahrzeug anwächst.

### Vorteile der Erfindung

Das erfindungsgemäße Steuergerät mit den kennzeichnenden Merkmalen des Anspruchs 1 vermeidet die bekannten Nachteile und ermöglicht es, Elektronikmodule mit unterschiedlichen Steuerfunktionen auf einem gemeinsamen Baugruppenträger anzuordnen, ohne daß eine aufwendige Leiterbahnführung und Anbindung der Elektronikmodule an eine gemeinsame Steckerleiste erforderlich ist. Vorteilhaft sind zum elektrischen Anschluß von Betriebseinrichtungen, beispielsweise Betriebseinrichtungen eines Kraftfahrzeuges, wie Motor, ABS, elektronisches Gaspedal, Abstandsradar usw., mehrere mit Kontaktelementen versehene, separate Steckerteile direkt auf der Bestückungsseite des Baugruppenträgers angeordnet, wobei jedem Elektronikmodul wenigstens ein Steckerteil zugeordnet ist, welches auf dem Baugruppenträger in der Nachbarschaft dieses Elektronikmoduls angeordnet ist und über auf dem Baugruppenträger aufgebrachte Leitungsverbindungen mit dem zugeordneten Elektronikmodul elektrisch leitend verbunden ist. Vorteilhaft wird durch die separaten Steckerteile die Anordnung und das Layout der Leitungsverbindungen auf dem Baugruppenträger stark vereinfacht. Die separaten Steckerteile werden einfach über kurze Leitungsverbindungen des Baugruppenträgers direkt mit den benachbart angeordneten Elektronikmodulen verbunden. Vorteilhaft kann die Größe des Baugruppenträger reduziert und der Integrationsgrad des Steuergerätes erhöht werden. Das Steuergerät kann in sehr einfacher Weise an unterschiedliche Anforderungsprofile angepaßt werden, indem weitere Elektronikmodule mit diesen zugeordneten Steckerteilen auf dem Baugruppenträger angeordnet oder weggelassen werden. Eine aufwendige Abänderung des Layouts bzw. der Leiterführung auf dem Baugruppenträger ist hierfür nicht erforderlich.

Vorteilhafte Ausgestaltungen und Weiterbildungen der Erfindung werden durch die in den Unteransprüchen angeführten Merkmale ermöglicht.

Vorteilhaft sind die Steckerteile zur Aufnahme von mit den Anschlußleitungen der Betriebseinrichtungen verbundenen Gegensteckern ausgebildet, welche Gegenstecker senkrecht zur Bestückungsseite des Baugruppenträgers in die Steckerteile einsteckbar sind. Hierdurch wird eine besonders hohe Integratrionsdichte auf dem Baugruppenträger erzielt, da kein zusätzlicher Platz an den Seiten der Steckerteile zum Einstecken der Gegenstecker bereitgestellt werden muß. Die Gegenstecker werden einfach in einer zur Bestücktungsseite des Baugruppenträgers senkrechten Richtung mit den Steckerteilen kontaktiert.

Weiterhin ist vorteilhaft, die Steckerteile als oberflächenmontierte Bauteile (SMD-Bauteile) auszubilden und die Kontaktelemente der Steckerteile mit ihren der Bestückungsseite des Baugruppenträgers zugewandten Endabschnitten auf die Leitungsverbindungen des Baugruppenträgers aufzulöten. Die SMD-Stecker können dann in einfacher Weise im gut beherrschten Reflow-Lötverfahren mit den Leitungsverbindungen verlötet werden.

Besonders vorteilhaft ist, wenn auf dem Baugruppenträger weitere Leitungsverbindungen vorgesehen sind, die ohne Zwischenschaltung von elektrischen oder elektronischen Bauelementen zumindest einen Teil der Kontaktelemente eines ersten Steckerteils untereinander oder mit einem Teil der Kontaktelemente eines zweiten Steckerteils elektrisch verbinden. Durch diese Maßnahme wird vermieden, daß die an die Steckerleisten angeschlossenen Anschlußkabel der Betriebseinrichtungen mit separaten Klemmleisten oder Steckerbrücken außerhalb des Steuergerätes versehen werden müssen. Beim Stand der Technik sind solche Klemmleisten und Steckerbrücken erforderlich, um die Adern der Kabelbäume außerhalb des Steuergerätes aufzuspalten, zu trennen oder miteinander zu verbinden. Diese Funktion des Kabelbaumes kann vorteilhaft von auf dem Baugruppenträger angeordneten Leitungsverbindungen übernommen werden. Dabei können insbesondere auch Steckerbrücken, welche die Kontaktelemente eines Steckerteils direkt miteinander verbinden, vorteilhaft auf dem Baugruppenträger angeordnet werden.

Vorteilhaft können wärmeerzeugende elektrische Leistungsbauelemente direkt auf die Bestückungsseite des Baugruppenträgers aufgebracht sein und über Leitungsverbindungen des Baugruppenträgers mit den Elektronikmodulen und/oder Steckerteilen elektrisch verbunden werden. Hierdurch wird ein besserer Wärmeübergang auf die Unterseite des Baugruppenträgers ermöglicht, der beispielsweise mit einer Wärmesenke gekoppelt sein kann.

Vorteihaft ist weiterhin, auf dem Baugruppenträger eine gemeinsame Stromversorgungseinrichtung und eine gemeinsame Signalaufbereitungseinrichtung für alle Elektronikmodule vorzusehen, die über Leitungsverbindungen des Baugruppenträgers mit den Elektronikmodulen und/oder Steckerteilen elektrisch leitend verbunden sind. Da eine separate Signalaufbereitung und Stromversorgungseinrichtung der Elektronikmodule entfällt, kann der Integrationsgrad des Steuergerätes weiter erhöht werden. Die Elektronikmodule selbst können in unterschiedlichen Herstellungstechnologien und damit für das jeweilige Elektronikmodul kostenoptimiert hergestellt werden.

Größere passive Bauelemente, die auf den Elektronikmodulen viel Platz beanspruchen würden, können direkt auf die Bestückungsseite des Baugruppenträgers aufgebracht und über Leitungsverbindungen des Baugruppenträgers mit den Elektronikmodulen elektrisch verbunden sein. Die Größe der Elektronikmodule kann hierdurch verkleinert werden, was insbesondere dann von vorteilhaft ist, wenn die Elektronikmodule ein teures Trägersubstrat aufweisen.

Weiterhin ist vorteilhaft, wenn die elektronische Steuerschaltung der einzelnen Elektronikmodule wenigstens einen eigenen Mikroprozessor umfaßt. Da die Steuerfunktionen der übrigen Elektronikmodule nicht von der Rechenleistung dieses Mikroprozessors abhängt, kann der Mikroprozessor vorteilhaft an die für die Steuerfunktion des Elektronikmoduls benötigte Rechenleistung angepaßt werden. Außerdem wird vermieden, daß beim Ausfall eines einzelnen Elektronikmoduls, die Funktion der übrigen Elektronikmodule beeinträchtigt wird. Die Zuverlässigkeit des Gesamtsystems kann somit vorteilhaft erhöht werden.

Zur besseren Wärmeableitung kann der Baugruppenträger mit der von der Bestückungsseite abgewandten Seite vorteilhaft auf ein als Wärmesenke dienendes Gehäuseteil des Steuergerätes aufgebracht sein.

### Zeichnung

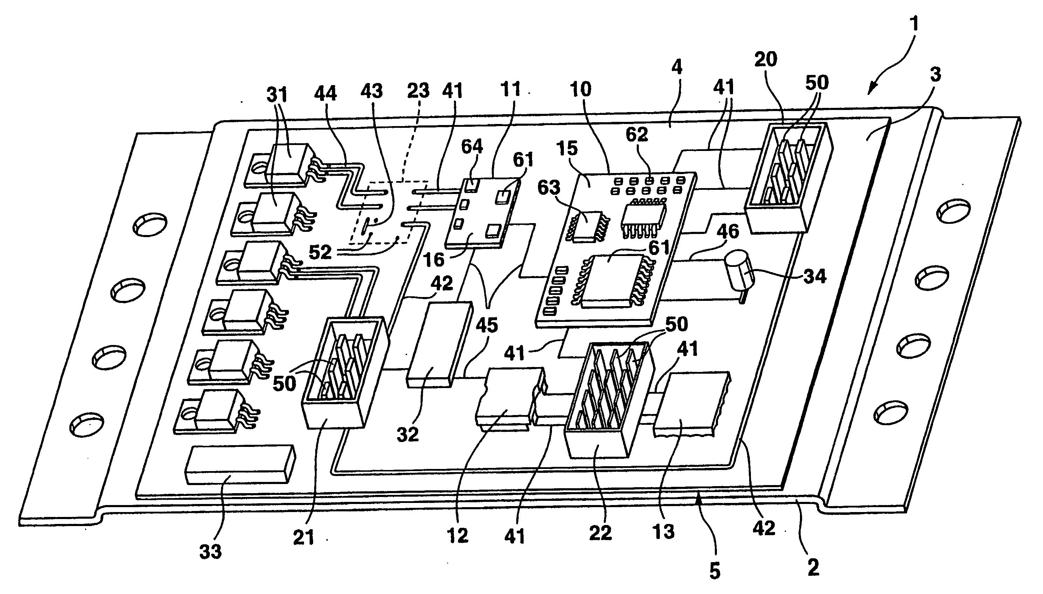

Ein Ausführungsbeispiel der Erfindung ist in den Zeichnungen dargestellt und wird in der nachfolgenden Beschreibung näher erläutert. Es zeigt
Fig. 1 eine perspektivische und schematische Darstellung eines erfindungsgemäßen Steuergerätes ohne Deckelteil.

### Beschreibung eines Ausführungsbeispiels

Fig. 1 zeigt eine schematische Darstellung eines erfindungsgemäßen Steuergerätes bei abgenommenem Gehäusedeckel. Ein Baugruppenträger 3, welcher zum Beispiel eine Mehrlagenleiterplatte, ein keramisches Mehrlagensubstrat, ein Kunststoffträger mit gestanzten Einlegeteilen oder eine dreidimensionale Leiterplatte, ein sogenanntes 3D-MID Substrat (Molded Interconnect Device) oder ein anderer Träger sein kann, ist mit seiner Unterseite 5 auf einen metallischen Gehäuseboden 2 aufgebracht. Auf den Gehäuseboden 2 kann ein nicht dargestellter Gehäusedeckel aufgesetzt werden, so daß der Baugruppenträger 3 geschützt in einem Steuergerätegehäuse angeordnet ist. Auf der der Unterseite 5 gegenüberliegenden Bestückungsseite 4 des Baugruppenträgers 3 sind mehrere Elektronikmodule 10,11,12 und 13 angeordnet, welche in unterschiedlichen Technologien hergestellt sein können. So umfaßt das Elektronikmodul 10 beispielsweise eine Leiterplatte 15 mit mehreren auf der Leiterplatte 15 angeordneten und über Leiterbahnen miteinander verbundenen Bauelementen 61,62,63. Das Elektronikmodul 11 ist beispielsweise als Keramiksubstrat 16 in Hybridtechnik mit Bauelementen 61,64 hergestellt. Ein anderes Elektronikmodul 12 ist beispielsweise als Multichipmodul (MCM) ausgebildet. Die elektrischen und elektronischen Bauelemente des Elektronikmoduls 13 sind direkt auf den Baugruppenträger aufgebracht und mit einer Schutzkappe abgedeckt. Auch andere Ausgestaltungen der Elektronikmodule sind möglich. Vorteilhaft ist, daß nicht alle Steuerschaltungen in der gleichen Herstellungstechnik gefertigt werden, sondern daß jedes Elektronikmodule in der hierfür preisgünstigsten Technik hergestellt werden kann.

Die elektrischen und elektronischen Bauelemente jedes Elektronikmoduls bilden eine elektronische Steuerschaltung zur Steuerung jeweils einer außerhalb des Steuergerätes angeordneten Betriebseinrichtung. Das in Fig. 1 gezeigte Steuergerät 1 kann beispielsweise in ein Kraftfahrzeug zur Ansteuerung verschiedener Betriebseinrichtungen des Kraftfahrzeuges eingebaut werden. Das Elekronikmodul 10 ist beispielsweise zur Ansteuerung einer Zündanlage vorgesehen, während das Elekronikmodul 11 zur Ansteuerung eines ABS-Systems (Antiblockiersystem) dient. Weitere Elektronikmodule 12,13 können beispielsweise zur Ansteuerung von motorisch betriebenen Fensterhebern oder zur Steuerung eines elektronischen Gaspedals dienen. Soll eine weitere Funktion des Steuergerätes bereitgestellt werden, so kann einfach ein weiteres Elektronikmodule auf den Baugruppenträger bestückt werden. Auf diese Weise ist eine sehr flexible Anpassung des Steuergerätes 1 an das jeweilige Anforderungsprofil möglich. Jedes Elektronikmodul weist wenigstens einen eigenen Mikroprozessor 61 auf, dessen Rechenleistung an die Steuerfunktion des Elektronikmoduls optimal angepaßt ist. Auf einen mehreren Elektronikmodulen gemeinsam zugeordneten Mikroprozessor, der immer so groß ausgelegt sein muß, daß seine Rechenleistung auch bei Aufnahme zusätzlicher Elektronikmodule auf dem Baugruppenträger ausreicht, wird verzichtet. Hierdurch wird vorteilhaft vermieden, daß bei Ausfall des Mikroprozessors eines Elektronikmoduls auch die übrigen Elektronikmodule ausfallen.

Weiterhin sind auf der Bestückungsseite 4 des Baugruppenträgers 3 mehrere separate Steckerteile 20,21 und 22 bestückt. Jedem Elekronikmodul ist dabei wenigstens ein Steckerteil zugeordnet. So ist beisielsweise dem Elektronikmodul 10 das Steckerteil 20 und das Steckerteil 22, dem Elektronikmodul 11 ein am Ort der gestrichelten Linie 23 aufzubringendes, nicht dargestelltes Steckerteil und den Elektronikmodulen 12,13 das Steckerteil 22 zugeordnet. Die Steckerteile sind in der Nachbarschaft der ihnen zugeordneten Elektronikmodule unmittelbar auf die Bestücktungsseite 4 des Baugruppenträgers aufgebracht und über Leitungsverbindungen 41 des Baugruppenträgers 3 mit den zugeordneten Elektronikmodulen elektrisch leitend verbunden. Dabei ist jedes Steckerteil so plaziert, daß unter Berücksichigung der Position der diesem Steckerteil zugeordneten Elektronikmodule die verschiedenen Leitungsverbindungen 41 zu den Elektronikmodulen insgesamt sehr kurz ausgebildet werden können. Die Leitungsverbindungen können als gedruckte Leiterbahnen, gestanzte Metallteile oder in anderer Form ausgebildet sein. Die Steckerteile 20,21,22 umfassen ein isolierendes Steckergehäuse mit mehreren darin angeordneten Kontaktelementen 50. Die Kontaktelemente 50 sind senkrecht zur Bestücktungsseite 4 ausgerichtet, so daß jeweils ein Gegenstekker, welcher mit dem Anschlußkabel einer Betriebseinrichtung verbunden ist, senkrecht zur Bestückungsseite 4 in das zugeordnete Steckerteil eingesteckt werden kann. Die der Bestükkungsseite 4 zugewandten Endabschnitte der Kontaktelemente 50 sind auf der Unterseite der Steckergehäuse mit den Leitungsverbindungen 41 kontaktiert. Wenn die Steckerteile 20,21,22 als SMD-Stecker (Surface Mounted Device) ausgebildet sind, ist es beispielsweise möglich, die Kontaktelemente 50 mit Anschlußflächen 52 der Leitungsverbindungen 41 im Reflow-Lötverfahren zu verlöten. Vorteilhaft können die Steckerteile dann zusammen mit anderen Bauelementen auf der Bestückungsseite des Baugruppenträgers aufgelötet werden. Die Steckerteile können aber auch mit von der Untersteite abstehenden Steckerfahnen in Durchkontaktierungen des Baugruppenträgers eingelötet werden oder in anderer Weise auf den Baugruppenträger 3 aufgebracht werden. Die Elektronikmodule 10 bis 13 können auf verschiedene Weise mit den Leitungsverbindungen verbunden werden. Beispielsweise kann die Leiterplatte 15 des Elektronikmoduls 10 auf der Unterseite mit Kontaktflächen versehen sein, die über Durchkontaktierugen mit den Bauelementen 61,62,63 und Leiterbahnen auf der Oberseite der Leiterplatte 15 verbunden sind. Die Kontaktflächen auf der Unterseite können dann über einen elektrisch leitfähigen Kleber oder über Löthöcker (Solder Bumps) mit den Leitungsverbindungen 41 kontaktiert werden. Es ist auch denkbar, die elektronische Schaltung der Elektronikmodule beispielsweise über Bonddrähte mit den Leitungsverbindungen zu kontaktieren. Wie am Beispiel des Elektronikmoduls 12 gezeigt, können die Elektronikmodule auch mit Anschlußbeinchen versehen sein und direkt auf der Bestückungsseite 4 auf die Leitungsverbindungen 41 aufgelötet werden.

Wie in Fig. 1 weiterhin dargestellt ist, sind auf der Bestücktungseite 4 des Baugruppenträgers 3 Leistungsbauelemente 31 aufgebracht. Die Leistungsbauelmente 31, welche sich im Betrieb stark erwärmen, können ihre Wärme vorteilhaft über die Unterseite des Baugruppenträgers 3 an den Gehäuseboden 2 abgeben. Die Leitungsbauelemente 31 sind über hochstromführende Leitungsverbindungen 44 des Baugruppenträgers mit den Steckerteilen oder Elektronikmodulen verbunden. Einzelne diskrete Bauelemente 34, die auf den Elektronikmodulen sehr viel Platz beanspruchen würden, wie beispielsweise große Kondensatoren, können direkt auf den Baugruppenträger 2 bestückt werden und über Leitungsverbindungen 46 mit dem zugeordneten Elektronikmodul 10 verbunden sein.

Darüber hinaus ist bei dem in Fig. 1 gezeigten Baugruppenträger vorgesehen, eine gemeinsame Stromversorgungseinrichtung 33 auf dem Baugruppenträger 3 vorzusehen. Die Stromversorgungseinrichtung 33 ist über nicht dargestellte Leitungsverbindungen des Baugruppenträgers 3, beispielsweise über ein großflächige innere Leiterbahn des Baugruppenträgers, mit den Elektronikmodulen und/oder Steckerteilen verbunden. Weiterhin ist eine allen Elektronikmodulen gemeinsame Signalaufbereitungseinrichtung 32 vorgesehen, die über Leitungsverbindungen 45 mit den Elektronikmodulen und/oder Steckerteilen 20,21,22 verbunden ist. So können beispielsweise von im Kraftfahrzeug angebrachten Sensoren erfaßte Daten über die Temperatur, Drehzahl oder Druckverhältnisse im Motor aufgearbeitet und an die Elektronikmodule übermittelt werden.

Wie in Fig. 1 weiterhin erkennbar ist, sind einzelne Leitungsverbindungen 42 auf dem Baugruppenträger vorgesehen, welche ein Kontaktelement 50 eines Steckerteils mit einem Kontaktelement 50 eines anderen Steckerteils verbinden. Die Kabelbaumverbindungen der Anschlußleitungen können so vorteilhaft bereits auf dem Baugruppenträger 3 hergestellt werden. Darüber hinaus ist es möglich, wie innerhalb der gestrichelten Linie 23 dargestellt, Steckerbrücken durch Leitungsverbindungen 43 des Baugruppenträgers zu bilden, welche zwei Kontaktelemente 50 eines Steckerteils untereinander verbinden.

Auf das Gehäusebodenteil 2 wird ein metallisches Deckelteil aufgesetzt, welches Ausnehmungen zur Aufnahme der Steckerteile 20,21,22 aufweist. Die Steckerteile können mit Dichtungsringen oder Kleberaupen in den Ausnehmungen des Deckelteil abgedichtet werden, so daß der Baugruppenträger 3 in einem geschlossen Steuergerätegehäuse angeordnet ist.

## Patentansprüche

1. Elektronisches Steuergerät mit einem Baugruppenträger (3) auf dessen Bestückungsseite (4) mehrere mit einer elektronischen Steuerschaltung versehenen Elektronikmodule (10,11, 12,13) angeordnet sind, wobei die elektronische Steuerschaltung eines Elektronikmoduls wenigstens eine Steuerfunktion zur Steuerung jeweils einer außerhalb des Steuergerätes angeordneten Betriebseinrichtung erzeugt, **dadurch gekennzeichnet, daß** zum elektrischen Anschluß der Betriebseinrichtungen an die Elektronikmodule (10,11,12,13) mehrere mit Kontaktelementen (50) versehene Steckerteile (20,21,22) separat auf der Bestückungsseite (4) des Baugruppenträgers (3) angeordnet sind, wobei jedem Elektronikmodul wenigstens ein Stekkerteil zugeordnet ist, welches auf dem Baugruppenträger in der Nachbarschaft dieses Elektronikmoduls angeordnet ist und über auf dem Baugruppenträger (3) aufgebrachte Leitungsverbindungen (41) mit diesem Elektronikmodul elektrisch leitend verbunden ist.

2. Elektronisches Steuergerät nach Anspruch 1, **dadurch gekennzeichnet, daß** die Steckerteile (20,21,22) zur Aufnahme eines mit den Anschlußleitungen der Betriebseinrichtungen verbundenen Gegensteckers ausgebildet sind, welche Gegenstecker senkrecht zur Bestückungsseite (4) des Baugruppenträgers (3) in die Steckerteile (20,21,22) einsteckbar sind.

3. Elektronisches Steuergerät nach Anspruch 2, **dadurch gekennzeichnet, daß** die Steckerteile (20,21,22) oberflächenmontierte Bauteile (SMD-Bauteile) sind und daß die Kontaktelemente (50) der Steckerteile mit ihren der Bestückungsseite (4) des Baugruppenträgers (3) zugewandten Endabschnitten auf die Leitungsverbindungen (41) des Baugruppenträgers aufgelötet sind.

4. Elektronisches Steuergerät nach einem der Ansprüche 1 bis 3, **dadurch gekennzeichnet, daß** auf dem Baugruppenträger weitere Leitungsverbindungen (42,43) vorgesehen sind, die ohne Zwischenschaltung von elektrischen oder elektronischen Bauelementen wenigstens ein Kontaktelement (50) eines Steckerteils (20) mit einem anderen Kontaktelement (50) desselben Steckerteils oder mit einem Kontaktelement (50) eines anderen Steckerteils (21) elektrisch verbinden.

5. Elektronisches Steuergerät nach Anspruch 1, **dadurch gekennzeichnet, daß** elektrische Leistungsbauelemente (31) direkt auf die Bestückungsseite (4) des Baugruppenträgers (3) aufgebracht sind und über Leitungsverbindungen (44) des Baugruppenträgers mit wenigstens einem Elektronikmodul und/oder wenigstens einem Steckerteil (21) elektrisch verbunden sind.

6. Elektronisches Steuergerät nach Anspruch 1, **dadurch gekennzeichnet, daß** auf dem Baugruppenträger (3) eine gemeinsame Stromversorgungseinrichtung (33) für alle Elektronikmodule (20,21,22) angeordnet ist, die über Leitungsverbindungen des Baugruppenträgers mit den Elektronikmodulen (20, 21,22) und/oder Steckerteilen (20,21,22) elektrisch leitend verbunden ist.

7. Elektronisches Steuergerät nach Anspruch 1, **dadurch gekennzeichnet, daß** auf dem Baugruppenträger (3) eine gemeinsame Signalaufbereitungseinrichtung (32) für alle Elektronikmodule (20,21,22) angeordnet ist, die über Leitungsverbindungen (45) des Baugruppenträgers mit den Elektronikmodulen (10,11,12) und/oder Steckerteilen (20,21,22) elektrisch leitend verbunden ist.

8. Elektronisches Steuergerät nach Anspruch 1, **dadurch gekennzeichnet, daß** größere passive Bauelemente (34) direkt auf die Bestückungsseite (4) des Baugruppenträgers (3) aufgebracht sind und über Leitungsverbindungen (46) des Baugruppenträgers mit den Elektronikmodulen (10,11,12) elektrisch verbunden sind.

9. Elektronisches Steuergerät nach Anspruch 1, **dadurch gekennzeichnet, daß** die elektronische Steuerschaltung eines Elektronikmoduls (10,11,12) wenigstens einen eigenen Mikroprozessor (61) umfaßt.

10. Elektronisches Steuergerät nach einem der vorstehenden Ansprüche, **dadurch gekennzeichnet, daß** der Baugruppenträger (3) mit der von der Bestückungsseite (4) abgewandten Seite (5) auf ein Gehäuseteil (2) des Steuergerätes aufgebracht ist.

## Claims

1. Electronic controller having a mounting rack (3) on whose components side (4) a plurality of electronic modules (10, 11, 12, 13) provided with an electronic control circuit are arranged, the electronic control circuit of an electronic module generating at least one control function for controlling in each case, one operating device arranged outside the controller **characterized in that** a plurality of male connector parts (20, 21, 22) provided with contact elements (50) are separately arranged on the components side (4) of the mounting rack (3) for electrically connecting the operating devices to the electronic modules (10, 11, 12, 13), each electronic module being assigned at least one male connector part which is arranged on the mounting rack in the vicinity of this electronic module and is electrically conductively connected to this electronic module by line connections (41) fitted on the mounting rack (3).

2. Electronic controller according to Claim 1, **characterized in that** the male connector parts (20, 21, 22) are designed to receive a mating connector connected to the connecting leads of the operating devices, which mating connectors can be plugged into the male connector parts (20, 21, 22) perpendicularly to the components side (4) of the mounting rack (3).

3. Electronic controller according to Claim 2, **characterized in that** the male connector parts (20, 21, 22) are surface-mounted components (SMD components), and **in that** the end sections, which face the components side (4) of the mounting rack (3), of the contact elements (50) of the male connector parts are soldered onto the line connections (41) of the mounting rack.

4. Electronic controller according to one of Claims 1 to 3, **characterized in that** further line connections (42, 43) are provided on the mounting rack and electrically connect at least one contact element (50) of a male connector part (20) to another contact element (50) of the same male connector part or to a contact element (50) of another male connector part (21), without the interconnection of electrical or electronic components.

5. Electronic controller according to Claim 1, **characterized in that** electrical power components (31) are fitted directly onto the components side (4) of the mounting rack (3) and are electrically connected to at least one electronic module and/or to at least one male connector part (21) by line connections (44) of the mounting rack.

6. Electronic controller according to Claim 1, **characterized in that** a common power supply device (33) for all the electronic modules (10, 11, 12) is arranged on the mounting rack (3) and is electrically conductively connected to the electronic modules (10, 11, 12) and/or male connector parts (20, 21, 22) by line connections of the mounting rack.

7. Electronic controller according to Claim 1, **characterized in that** a common signal conditioning device (32) for all the electronic modules (10, 11, 12) is arranged on the mounting rack (3) and is electrically conductively connected to the electronic modules (10, 11, 12) and/or male connector parts (20, 21, 22) by line connections (45) of the mounting rack.

8. Electronic controller according to Claim 1, **characterized in that** relatively large passive components (34) are fitted directly onto the components side (4) of the mounting rack (3) and are electrically connected to the electronic modules (10, 11, 12) by line connections (46) of the mounting rack.

9. Electronic controller according to Claim 1, **characterized in that** the electronic control circuit of an electronic module (10, 11, 12) comprises at least one dedicated microprocessor (61).

10. Electronic controller according to one of the preceding claims, **characterized in that** the side (5) of the mounting rack (3) facing away from the components side (4) is fitted onto a housing part (2) of the controller.

## Revendications

1. Appareil de commande électronique comprenant un support de composants (3) qui présente sur sa face de chargement (4) plusieurs modules électroniques (10, 11, 12, 13) munis d'un circuit de commande électronique, le circuit de commande électronique d'un module électronique ayant au moins une fonction de commande pour commander à chaque fois une installation fonctionnelle disposée à l'extérieur de l'appareil
**caractérisé en ce que**
pour raccorder électriquement les installations fonctionnelles aux modules électroniques (10, 11, 12, 13), plusieurs éléments de connexion (20, 21, 22) munis d'éléments de contact (50) sont disposés séparément sur la face de chargement (4) du support de composants (3), et à chaque module électronique est associé à au moins un élément connecteur qui est disposé sur le support de composants à proximité de ce module électronique et relié de manière électriquement conductrice à ce module électronique par le biais de liaisons électriques (41) disposées sur le support de composant (3).

2. Appareil de commande électronique selon la revendication 1,
**caractérisé en ce que**
les éléments de connexion (20, 21, 22) sont destinés à recevoir une contre-connexion reliée aux lignes de raccordement des installations fonctionnelles, ces contre-connexions étant insérées dans les éléments de connexion (20, 21, 22) perpendiculairement à la face de chargement (4) du support de composants (3).

3. Appareil de commande électronique selon la revendication 2,
**caractérisé en ce que**
les éléments de connexion (20, 21, 22) sont des composants de surface (composants SMD) et les éléments de contact (50) des éléments de connexion sont soudés, avec leurs parties d'extrémité en regard de la face de chargement (4) du support de composants (3), sur les liaisons électriques (41) du support de composant.

4. Appareil de commande électronique selon l'une des revendications 1 à 3,
**caractérisé en ce que**
sur le support de composants, d'autres liaisons électriques (42, 43) sont prévues pour relier électriquement, sans interposer de composants électriques ou électroniques, au moins un élément de contact (50) d'un élément de connexion (20) avec un autre élément de contact (50) du même élément de connexion ou avec un élément de contact (50) d'un autre élément de connexion (21).

5. Appareil de commande électronique selon la revendication 1,
**caractérisé en ce que**
les composants des liaisons électriques (31) sont déposés directement sur la face de chargement (4) du support de composants (3) et sont reliés électriquement, par le biais de liaisons électriques (44) du support de composants à au moins un module électronique et/ou à au moins un élément de connexion (21).

6. Appareil de commande électronique selon la revendication 1,
**caractérisé en ce que**
sur le support de composants (3), est disposé un système d'alimentation électrique (33) commun à tous les modules électroniques (20, 21, 22) et relié de manière électriquement conductrice aux modules électroniques (20, 21, 22) et/ou aux éléments de connexion (20, 21, 22) par le biais de liaisons électriques du support de composants.

7. Appareil de commande électronique selon la revendication 1,
**caractérisé en ce que**
sur le support de composants (3), est disposé un système de préparations de signaux (32) commun à tous les modules électroniques (20, 21, 22) et relié de manière électriquement conductrice, par le biais de liaisons électriques (45) du support de composant, aux modules électroniques (10, 11, 12) et/ou aux éléments de connexion (20, 21, 22).

8. Appareil de commande électronique selon la revendication 1,
**caractérisé en ce que**
des composants passifs plus importants (34) sont directement disposés sur la face de chargement (4) du support de composant (3) et sont reliés électriquement aux modules électroniques (10, 11, 12) par le biais de liaisons électriques (46) du support de composants.

9. Appareil de commande électronique selon la revendication 1,
**caractérisé en ce que**
le circuit de commande électronique d'un module électronique (10, 11, 12) comprend au moins un microprocesseur (61) propre.

10. Appareil de commande électronique selon l'une quelconque des revendications précédentes,
**caractérisé en ce que**
le support de composants (3) est disposé, par sa face opposée à la face de chargement (4), sur un élément de boîtier (2) de l'appareil.
